# EUROPÄISCHE PATENTANMELDUNG

(11) **EP 1 596 259 A1**
(43) Veröffentlichungstag der Anmeldung: **16.11.2005**
(21) Anmeldenummer: 04405300.7
(22) Anmeldetag: 10.05.2004
(51) Int. Cl.: G04B 13/02

(54) **Verfahren zum Herstellen von metallischen Körpern geringer Höhe, insbesondere von Uhrenbestandteilen**

(71) Anmelder: Precision Engineering AG, 8200 Schaffhausen (CH)
(72) Erfinder: Lange, Jürgen R., 8200 Schaffhausen (CH)
(74) Vertreter: Dr. Graf & Partner

(57) **Zusammenfassung**

Die Zähne (4) eines Zahnrades (2) für ein Räderwerk einer Uhr weisen Zahnflanken (3) auf, die mit den Zahnflanken oder den Funktionsflächen anderer Uhrenbestandteile in Berührung kommen. Diese Zahnflanken (3) sind sehr glatt und weisen herstellungsbedingt eine hohe Oberflächengüte auf. Die Rauhigkeit der Zahnflanken (3) ist geringer als 50 nm. Diese Oberflachenqualität wird dadurch erreicht, dass das Zahnrad mittels des LIGA-Verfahrens hergestellt wird.

## Beschreibung

Die vorliegende Erfindung betrifft ein Verfahren zum Herstellen von metallischen Körpern geringer Höhe, die funktionell und/oder ästhetisch wirkende Seitenflächen aufweisen, gemäss Oberbegriff des Anspruches 1, sowie nach diesem Verfahren hergestellte metallische Körper.

Dieser Erfindung liegt die Aufgabe zugrunde, ein Verfahren zu schaffen, mit dem auf kostengünstige Weise metallische Körper geringer Höhe hergestellt werden können, deren Seitenflächen eine derart geringe Oberflächenrauhigkeit aufweisen, dass diese Seitenflächen ohne aufwändige Nachbearbeitung die gewünschte ästhetische und/oder funktionelle Wirkung entfalten können.

Mit dieser Erfindung wird insbesondere auch bezweckt, ein Verfahren zu schaffen, mit dem auf kostengünstige Weise metallische Uhrenbestandteile hergestellt werden können, deren mit andern Uhrenbestandteilen in Berührung kommenden Funktionsflächen eine geringere Oberflächenrauhigkeit aufweisen als die Funktionsflächen von auf herkömmliche Weise hergestellten Uhrenbestandteilen.

Diese Aufgabe wird erfindungsgemäss mit einem Verfahren mit den Merkmalen des Anspruches 1 gelöst. Nach diesem Verfahren hergestellte Körper weisen die Merkmale des Anspruches 6 auf.

Mit dem erfindungsgemässen Verfahren lassen sich Körper geringer Höhe, zum Beispiel mit einer Höhe im Bereich von einigen Hundertstelmillimeter bis etwa 3 mm, von sehr hoher Präzision herstellen, die als wichtiges Merkmal äusserst glatte Seitenflächen aufweisen, die eine entsprechende optische Wirkung haben und damit auch eine ästhetische Funktion übernehmen. Somit eignet sich das erfindungsgemässe Verfahren auch zur Herstellung von Körpern mit rein optischer, ästhetischer Funktion. Die mit dem erfindungsgemässen Verfahren hergestellten Körper geringer Höhe könnten in einer weiteren Ausführungsform beispielsweise auch eine Höhe im Bereich von einem Hundertstelmillimeter bis 10 mm aufweisen.

Die geringe Oberflächenrauhigkeit der glatten Seitenflächen erweist sich insbesondere dann als vorteilhaft, wenn diese Seitenflächen als Funktionsflächen an Uhrenbestandteilen ausgebildet werden, die mit andern Uhrenbestandteilen in Berührung kommen. Dank dieser geringen Oberflächenrauhigkeit wird unter anderem beim reibenden Eingriff der Funktionsflächen mit andern Uhrenbestandteilen der Verschleiss vermindert sowie eine momenten- oder winkelgetreue und auch eine kombinierte winkel- und momentengetreue Uebertragung von Bewegungen mit verbessertem Wirkungsgrad sichergestellt.

Vorzugsweise werden die Körper nach dem an sich bekannten LIGA-Verfahren hergestellt. Dieses Verfahren wird auf Deutsch beispielsweise auch als "Lithographie, Galvanoformung, Abformung" bezeichnet, und auf Englisch als "LIGA-Technology" bezeichnet. Dabei wird für die Herstellung einer Negativform der Körper vorzugsweise ein Tiefenlithographieverfahren und insbesondere ein Röntgentiefenlithographieverfahren eingesetzt.

Andere bevorzugte Weiterausgestaltungen des Erfindungsgegenstandes sind in den übrigen abhängigen Ansprüchen umschrieben.

Im folgenden wird anhand der Figuren ein Ausführungsbeispiel des Erfindungsgegenstandes näher erläutert. Es zeigt:
- Fig. 1: in einer perspektivischen Darstellung ein Zahnrad für ein Getriebe einer Uhr,
- Fig. 2: in einem gegenüber der Fig. 1 vergrössertem Massstab einen Teil des in Fig. 1 gezeigten Zahnrades, und
- Fig. 3: rein schematisch und im Schnitt einen Teil der Negativform zur Herstellung des Zahnrades gemäss Fig. 1.

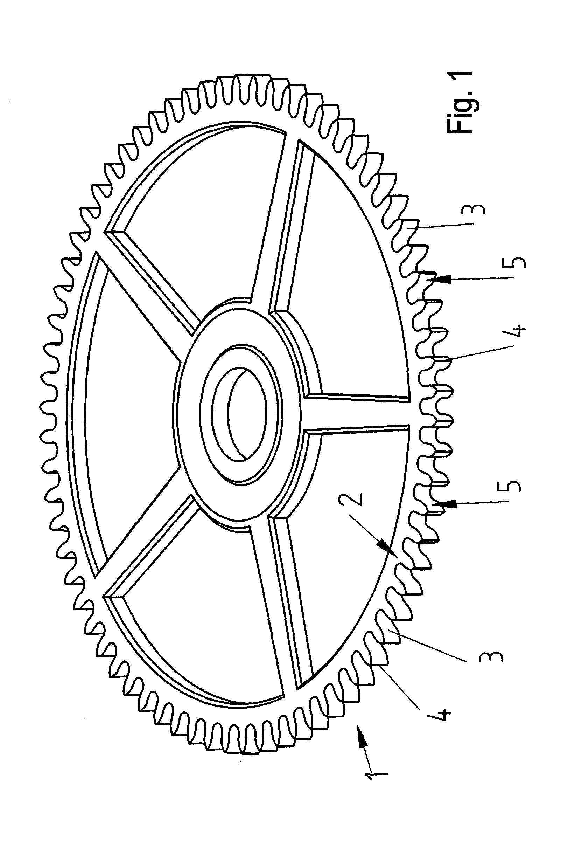

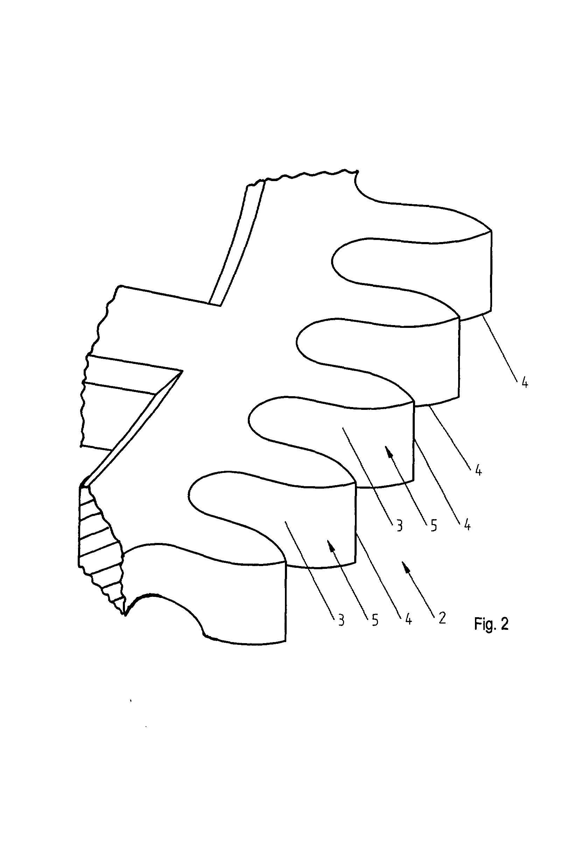

In den Fig. 1 und 2 ist ein Beispiel für einen nach dem erfindungsgemässen Verfahren hergestellten Körper geringer Höhe dargestellt, nämlich ein Uhrenbestandteil 1 in der Form eines Zahnrades 2 für ein Getriebe. Die Flanken 3 der Zähne 4 des Zahnrades 2 bilden die Seitenflächen des Uhrenbestandteils 1 und sind als Funktionsflächen 5 ausgestaltet. Diese Funktionsflächen 5 kommen in Berührung mit andern Uhrenbestandteilen bzw. deren Funktionsflächen, z.B. mit den Zahnflanken anderer Zahnräder oder mit den Funktionsflächen von Schalt- oder Sperrklinken.

Diese Funktionsflächen 5 sind sehr glatt und haben herstellungsbedingt eine Rauhigkeit von weniger als 50 nm (50 x 10⁻⁹ m). Diese hohe Oberflächengüte der Funktionsflächen 5 wirkt sich während des Betriebs, bei dem die Funktionsflächen 5 in reibender, antreibender oder angetriebener Berührung mit andern Uhrenbestandteilen bzw. deren Funktionsflächen stehen, hinsichtlich Wirkungsgrad, Verschleiss und Geräuschbildung sowie hinsichtlich der benötigten Menge von Schmiermittel vorteilhaft aus. Zudem wirken die spiegelglatten Funktionsflächen 5 optisch sehr ansprechend und entfalten eine ästhetische Wirkung. Somit lassen sich mit dem erfindungsgemässen Verfahren auch Teile mit rein optischer, ästhetischer Funktion herstellen.

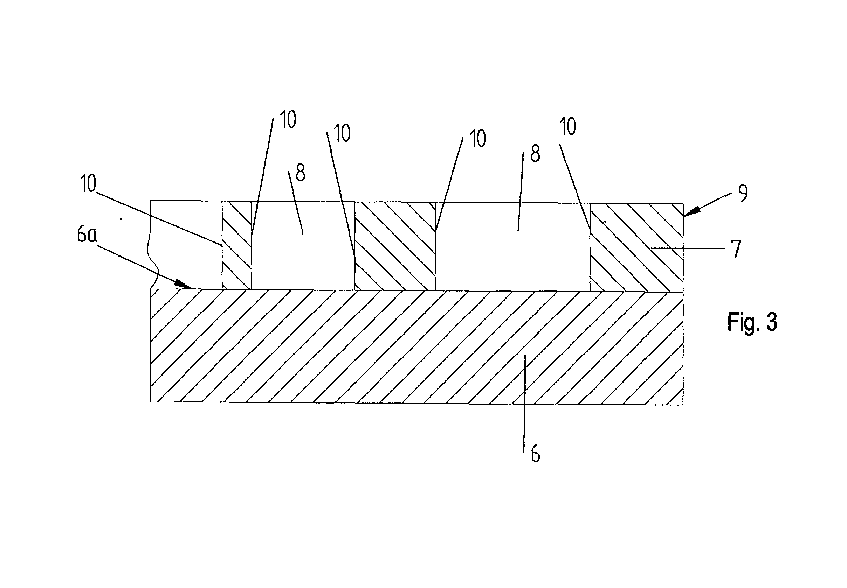

Wie bereits erwähnt ist die qualitativ hochstehende Oberflächenbeschaffenheit der Funktionsflächen 5 das Resultat des Herstellungsprozesses. Die Uhrenbestandteile 1, im vorliegenden Ausführungsbeispiel das Zahnrad 2, werden mittels des sogenannten LIGA-Verfahrens hergestellt, das an sich bekannt ist. Dabei wird vom herzustellenden Uhrenbestandteil 1 mittels eines Lithographieverfahrens, vorzugsweise mittels eines Röntgentiefenlithographieverfahrens, eine Negativform hergestellt. Dies soll nun anhand der schematischen Fig. 3 kurz erläutert werden.

Auf eine metallische Trägerschicht 6 wird eine für Röntgenstrahlen empfindliche Kunststoffschicht, Resistschicht 7 genannt, aufgebracht. Diese Resistschicht 7 kann beispielsweise aus Polymethylmethacrylat (PMMA) bestehen. Die Resistschicht 7 wird über eine, dem herzustellenden Uhrenbestandteil nachgebildete Röntgenmaske mit Absorberstrukturen mit parallelen Röntgenstrahlen belichtet. Dabei werden diejenigen Bereiche, die nicht durch die Absorberstrukturen der Röntgenmaske abgeschattet werden, in ihrer Struktur verändert. Anschliessend werden die der Röntgenstrahlung ausgesetzt gewesenen Bereiche der Resistschicht 7 herausgelöst. Dabei entstehen in der Resistschicht 7 Hohlräume 8 und es wird so eine Negativform 9 des herzustellenden Uhrenbestandteils 1 gebildet. Die im wesentlichen senkrecht zur Trägerschicht 6 verlaufenden Seitenwände 10 der Hohlräume 8, an denen die Funktionsflächen 5 des Uhrenbestandteils 1 ausgebildet werden, sind glatt und haben eine sehr hohe Oberflächengüte. Gleiches gilt auch für die obere Fläche 6a der Trägerschicht 6, wenn diese vorgängig auf Hochglanz poliert wurde.

Die Hohlräume 8 der Negativform 9 werden nun mit einem Metall oder einer Metalllegierung aufgefüllt. Dies geschieht auf galvanischem Weg unter Verwendung der metallischen Trägerschicht 6 als Elektrode. Die dabei entstehende Metallstruktur ist nun der gewünschte Uhrenbestandteil 1, d.h. im vorliegenden Ausführungsbeispiel das Zahnrad 2. Wie bereits erwähnt sind die Funktionsflächen 5 des Uhrenbestandteils 2, d.h. die Flanken 3 der Zähne 4, an den glatten Seitenwänden 10 der Hohlräume 8 der Negativform 9 ausgebildet worden. Aus diesem Grund haben diese Funktionsflächen 5 die früher erwähnte Oberflächenqualität.

Zur Bildung des Uhrenbestandteils 1 in der Negativform 9 eignen sich grundsätzlich alle Materialien, die galvanisch aufgebracht werden können, so z.B. Nickel und seine Legierungen (insbesondere Nickel Phosphor- und Nickel-Eisen-Legierungen), Gold, Platin.

Zur Bildung der Negativform 9 können selbstverständlich auch andere Lithographieverfahren als das erwähnte Röntgentiefenlithographieverfahren eingesetzt werden. Auch können andere Materialien als PMMA für die Resistschicht 7 verwendet werden, z.B. SU-8 (Handelsbezeichnung).

Ausser Zahnrädern für Rädergetriebe lassen sich auf die erfindungsgemässe Weise auch andere Arten von Uhrenbestandteilen herstellen, so z.B. Sperr- oder Schaltklinken von Sperrwerken und Schaltgetrieben, Hebel, Führungskulissen, Anker, Ankerräder, Zifferblätter, Indexe, Ziffern und dgl.

Ausser Uhrenbestandteilen lassen sich mit dem erfindungsgemässen und vorstehend beschriebenen Verfahren wie bereits erwähnt auch Teile oder Körper geringer Höhe für andere Anwendungsgebiete herstellen, die eine rein optische, ästhetische Funktion zu erfüllen haben, z.B. Schmuckstücke und Teile hiervon.

Solche in der Schmuckindustrie verwendeten Teile oder Körper haben eine geringe Höhe, d.h. vorzugsweise eine Höhe von einigen Hundertstelmillimetern bis etwa 3 Millimeter, und - wie beschrieben - herstellungsbedingt glatte Seitenflächen, die zur Erzielung des gewünschten optischen Effektes nicht mehr nachbearbeitet werden müssen. Eine solche Nachbearbeitung wäre wegen der kleinen Abmessungen (Höhe) dieser Seitenflächen oft kaum oder nur mit einem sehr grossen Aufwand möglich.

## Patentansprüche

1. Verfahren zum Herstellen von metallischen Körpern (1) geringer Höhe, die funktionell und/oder ästhetisch wirkende Seitenflächen (5) aufweisen, **dadurch gekennzeichnet, dass** vom herzustellenden Körper (1) mittels eines Lithographieverfahrens in einer strahlenempfindlichen Kunststoffschicht (7) eine Negativform (9) erzeugt wird, bei der die Seitenwände (10) ihrer Hohlräume (8) zur Bildung der Seitenflächen (5) des Körpers (1) bestimmt sind, und dass anschliessend die Hohlräume (8) der Negativform (9) mit einem metallischen Werkstoff aufgefüllt werden, wobei an den Seitenwänden (10) der Hohlräume (8) der Negativform (9) die Seitenflächen (5) des Körpers (1) ausgebildet werden.

2. Verfahren nach Anspruch 1 zum Herstellen von metallischen Uhrenbestandteilen (1), deren Seitenflächen als Funktionsflächen (5) ausgebildet sind, die mit andern Uhrenbestandteilen in Berührung kommen und die an den Seitenwänden (10) der Hohlräume (8) der Negativform (9) ausgebildet werden.

3. Verfahren nach Anspruch 1 oder 2, **dadurch gekennzeichnet, dass** die Negativform (9) mittels Tiefenlithographie, vorzugsweise mittels Röntgentiefenlithographie, erzeugt wird.

4. Verfahren nach einem der Ansprüche 1 bis 3, **dadurch gekennzeichnet, dass** die Hohlräume (8) der Negativform (9) galvanisch mit dem metallischen Werkstoff aufgefüllt werden.

5. Verfahren nach einem der Ansprüche 2 bis 4 zur Herstellung von Elementen eines Getriebes oder eines Sperr- oder Schaltwerkes für Uhren, z.B. von Zahnrädern (2).

6. Metallischer Körper (1) geringer Höhe, der funktionell und/oder ästhetisch wirkende Seitenflächen (5) aufweist, hergestellt nach dem Verfahren gemäss Anspruch 1, **dadurch gekennzeichnet, dass** die Rauhigkeit der Seitenflächen (5) weniger als 50 nm beträgt.

7. Metallischer Körper nach Anspruch 6, **dadurch gekennzeichnet, dass** er ein Uhrenbestandteil (1) ist, dessen Seitenflächen als Funktionsflächen (5) ausgebildet sind, die mit andern Uhrenbestandteilen in Berührung kommen.

8. Metallischer Körper nach Anspruch 6 oder 7, **dadurch gekennzeichnet, dass** er aus einem metallischen Werkstoff besteht, der galvanisch in Hohlräume (8) einer Negativform (9), die mittels eines Lithographieverfahrens in einer strahlenempfindlichen Kunststoffschicht (7) erzeugt wurde, eingefüllt worden ist.

9. Metallischer Körper nach Anspruch 7 oder 8, **dadurch gekennzeichnet, dass** er ein Element eines Getriebes oder eines Sperr- oder Schaltwerks für Uhren, z.B. ein Zahnrad (2), ist.
